# EUROPEAN PATENT APPLICATION

(11) **EP 4 629 436 A1**
(43) Date of publication of application: **08.10.2025**
(21) Application number: 23918111.8
(22) Date of filing: 28.01.2023
(51) Int. Cl.: H01P 1/20

(54) **DIELECTRIC FILTER, RADIO FREQUENCY PROCESSING UNIT, AND BASE STATION**

(71) Applicant: Huawei Technologies Co., Ltd., Shenzhen, Guangdong 518129 (CN)
(72) Inventor: MAO, Chenyang, Shenzhen, Guangdong 518129 (CN); YUAN, Bengui, Shenzhen, Guangdong 518129 (CN); SHI, Jing, Shenzhen, Guangdong 518129 (CN)
(74) Representative: Isarpatent
(86) International application number: PCT/CN2023/073622
(87) International publication number: WO 2024/156104

(57) **Abstract**

This application relates to the field of communication technologies, and discloses a dielectric filter, a radio frequency processing unit, and a base station, to increase a port coupling coefficient of the dielectric filter and expand a bandwidth of the dielectric filter. The dielectric filter includes a dielectric body, and a coupling port and one or more resonant cavities that are provided at the dielectric body. The dielectric body has a first surface, a second surface, and a side surface. The first surface and the second surface are opposite to each other. The coupling port extends from the side surface to an interior of the dielectric body. The coupling port includes a blind hole provided on the first surface, a first slot provided on the second surface, and a second slot provided on the side surface. The first slot extends in a direction of the side surface and communicates with the second slot. A projection of an outer contour of the first slot on the first surface covers at least a part of the blind hole. The blind hole, the first slot, and the second slot each have a metalized inner wall. The blind hole may be coupled to the first slot.

## Description

### TECHNICAL FIELD

This application relates to the field of communication technologies, and in particular, to a dielectric filter, a radio frequency processing unit, and a base station.

### BACKGROUND

With development of modern wireless communication technologies, communication systems tend to be miniaturized, integrated, and multi-functional. Correspondingly, the communication systems have increasingly high requirements for radio frequency links. Filters are important components of radio frequency front-end links. Currently, dielectric filters are widely used in the communication systems due to features of small size, low insertion loss, and good stability. However, the current dielectric filters commonly have a problem of weak strength of coupling between a connection port and a resonant cavity, resulting in a specific transmission delay and affecting further improvement of bandwidths of the filters.

### SUMMARY

This application provides a dielectric filter, a radio frequency processing unit, and a base station, to increase a port coupling coefficient of the dielectric filter and expand a bandwidth of the dielectric filter.

According to a first aspect, this application provides a dielectric filter. The dielectric filter may include a dielectric body, and a coupling port and one or more resonant cavities that are provided at the dielectric body. The dielectric body may include a first surface, a second surface, and a side surface. The first surface and the second surface are opposite to each other. The coupling port may extend from the side surface of the dielectric body to an interior of the dielectric body. The coupling port may include a blind hole, a first slot, and a second slot. The blind hole may be provided on the first surface of the dielectric body. The first slot may be provided on the second surface of the dielectric body. The second slot may be provided on the side surface of the dielectric body. The first slot may extend in a direction of the side surface of the dielectric body and communicate with the second slot. A projection of an outer contour of the first slot on the first surface of the dielectric body may cover at least a part of the blind hole. The blind hole, the first slot, and the second slot each have a metalized inner wall. The blind hole is coupled to the first slot.

In the foregoing solution, the second slot communicating with the first slot is provided on the side surface of the dielectric body. As a result, an entire slot structure formed by the first slot and the second slot can be used as a resonant cavity of the dielectric filter, and the two slots have opposite impact on a resonance frequency of the resonant cavity. In addition, a depth of the first slot affects strength of coupling between the first slot and the blind hole. Based on this principle, the depth of the first slot and a depth of the second slot are properly designed, to improve port coupling strength of the dielectric filter and reduce a delay while the dielectric filter remains at an original resonance frequency. As a result, a bandwidth of the dielectric filter is expanded.

For example, an electroplating process may be performed on an inner wall of the blind hole, the first slot, or the second slot to form the metalized inner wall, where a metal material includes but is not limited to silver, gold, tin, or the like.

In some possible implementations, an arrangement direction of the first surface and the second surface of the dielectric body is defined as a first direction, and the depth of the first slot is different from the depth of the second slot in the first direction. A greater depth of the first slot indicates a lower resonance frequency of the resonant cavity, and a smaller depth of the first slot indicates a higher resonance frequency of the resonant cavity. A greater depth of the second slot indicates a higher resonance frequency of the resonant cavity, and a smaller depth of the second slot indicates a lower resonance frequency of the resonant cavity. In this case, the depth of the first slot and the depth of the second slot are adjusted, so that the resonance frequency of the resonant cavity can meet a requirement for specific performance of the dielectric filter.

For example, the depth of the second slot may be greater than the depth of the first slot in the first direction. When the depth of the first slot is increased to improve the port coupling strength of the dielectric filter, a resonance frequency of the resonant cavity is reduced. If there is a need to remain at the original resonance frequency, the depth of the second slot may be further increased, so that the depth of the second slot is greater than the depth of the first slot. In this way, a frequency reduction caused by the first slot can be offset by a frequency increase caused by the second slot. As a result, the port coupling strength is improved, a delay is reduced, and the dielectric filter can remain at the original resonance frequency.

In some possible implementations, a projection of an outer contour of the second slot on the first surface may be spaced from the blind hole, to reduce a risk that the second slot interferes with the blind hole when the depth of the second slot is relatively large, and improve structural reliability of the dielectric filter.

In some possible implementations, the first slot may include a semicircular slot and a rectangular slot, the semicircular slot is located on a side that is of the rectangular slot and that is away from the side surface of the dielectric body, and an opening of the semicircular slot faces the rectangular slot, so that the semicircular slot communicates with the rectangular slot at the opening. This design can improve a quality factor of the dielectric filter, thereby helping improve filtering performance of the dielectric filter.

In some possible implementations, the dielectric body may be a cuboid. In this case, in addition to the first surface and the second surface, the dielectric body further includes four side surfaces that are opposite to each other in pairs, and the second slot of the coupling port may be provided on one of the side surfaces of the dielectric body.

In some other possible implementations, the dielectric body may be a cylinder. In this case, the second slot of the coupling port is provided on a circumferential surface of the dielectric body.

In some possible implementations, a material of the dielectric body may be ceramic. For example, a main component of the dielectric body includes but is not limited to a high-dielectric-constant ceramic such as barium titanate or barium carbonate.

According to a second aspect, this application further provides a radio frequency processing unit. The radio frequency processing unit may include a power amplifier and the dielectric filter in any one of the possible implementations of the first aspect. The coupling port of the dielectric filter is connected to the power amplifier, to perform the following: in a transmitting direction, filtering a signal and transmitting the filtered signal to the power amplifier for amplification, or in a receiving direction, filtering a signal amplified by the power amplifier.

In some possible implementations, the blind hole of the coupling port may be electrically connected to the power amplifier through a coaxial cable.

According to a third aspect, this application further provides a base station. The base station may include an antenna, a baseband unit, and the radio frequency processing unit in the second aspect. The radio frequency processing unit is connected between the baseband unit and the antenna. The dielectric filter in the radio frequency processing unit can implement wideband filtering. As a result, a communication capability of the base station can be improved.

### BRIEF DESCRIPTION OF DRAWINGS

FIG. 1 is a diagram of a system architecture according to an embodiment of this application;
FIG. 2 is a diagram of a structure of a base station according to an embodiment of this application;
FIG. 3 is a diagram of composition and a structure of an active antenna unit according to an embodiment of this application;
FIG. 4 is a diagram of a structure of a dielectric filter according to an embodiment of this application;
FIG. 5 is a diagram of a partial structure of the dielectric filter shown in FIG. 4;
FIG. 6 is a diagram of a cross-sectional structure of the dielectric filter, shown in FIG. 5, from a side perspective;
FIG. 7a shows a simulation result of a port delay of a conventional dielectric filter; and
FIG. 7b shows a simulation result of a port delay of a dielectric filter according to an embodiment of this application.

Reference numerals:
1-active antenna unit; 11-radome; 12-antenna; 121-reflecting plate; 122-antenna element; 13-radio frequency processing unit;
131-frequency converter; 132-filter; 1321-dielectric body; 13211-first surface of the dielectric body;
13212-second surface of the dielectric body; 13213-side surface of the dielectric body; 1322-coupling port; 13221-blind hole;
13222-first slot; 132221-semicircular slot; 132222-rectangular slot; 13223-second slot;
133-power amplifier; 1323-resonant cavity; 1324-coupling window; 2-pole; 3-antenna adjustment bracket;
4-baseband unit.

### DESCRIPTION OF EMBODIMENTS

To make the objectives, technical solutions, and advantages of this application clearer, the following further describes this application in detail with reference to the accompanying drawings.

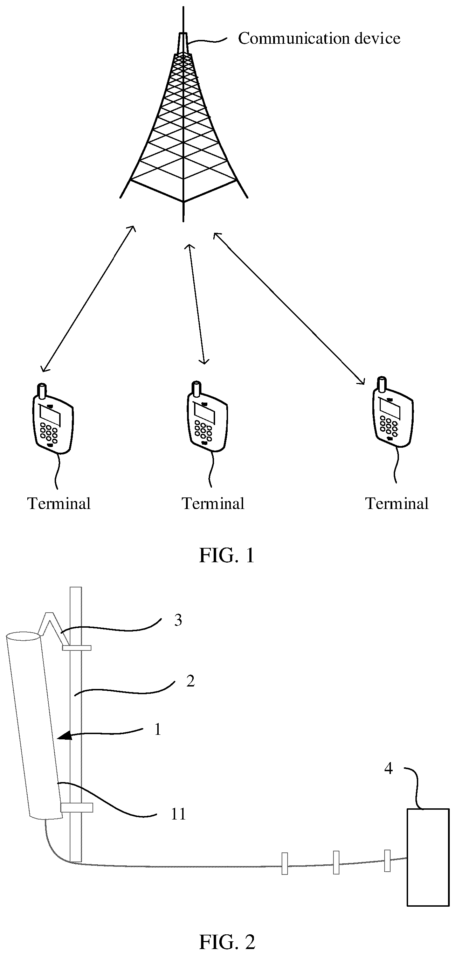

FIG. 1 is a diagram of an example of a system architecture to which an embodiment of this application is applicable. As shown in FIG. 1, the system architecture includes a communication device of a radio access network and terminals, and wireless communication may be performed between the communication device and the terminals. The embodiment shown in FIG. 1 is described by using an example in which the communication device is a base station. The base station may be in a base station subsystem (base station subsystem, BSS), a terrestrial radio access network (UMTS terrestrial radio access network, UTRAN), or an evolved terrestrial radio access network (evolved universal terrestrial radio access network, E-UTRAN), and is configured to provide cell coverage of radio signals, to implement a connection between a terminal device and a radio frequency end of the radio network. Specifically, the base station may be a base transceiver station (base transceiver station, BTS) in a GSM system or a CDMA system, may be a NodeB (NodeB, NB) in a WCDMA system, may be an evolved NodeB (evolved NodeB, eNB or eNodeB) in a long term evolution (long term evolution, LTE) system, or may be a radio controller in a cloud radio access network (cloud radio access network, CRAN) scenario. Alternatively, the base station may be a relay station, an access point, a vehicle-mounted device, a wearable device, a base station in a 5G network, a base station in a future evolved public land mobile network (public land mobile network, PLMN), or the like, for example, a new radio base station. This is not limited in embodiments of this application.

FIG. 2 is a diagram of a structure of a base station according to an embodiment of this application. The base station includes structures such as an active antenna unit (active antenna unit, AAU) 1, a pole 2, an antenna adjustment bracket 3, and a baseband unit (baseband unit, BBU) 4. The AAU 1 may include a radome 11. The radome 11 features good electromagnetic-wave penetration in terms of electrical performance, and can withstand impact of a harsh external environment in terms of mechanical performance, thereby protecting the AAU from the impact of the external environment. The radome 11 may be mounted on the pole 2 or a tower through the antenna adjustment bracket, to facilitate receiving or transmitting of an antenna signal.

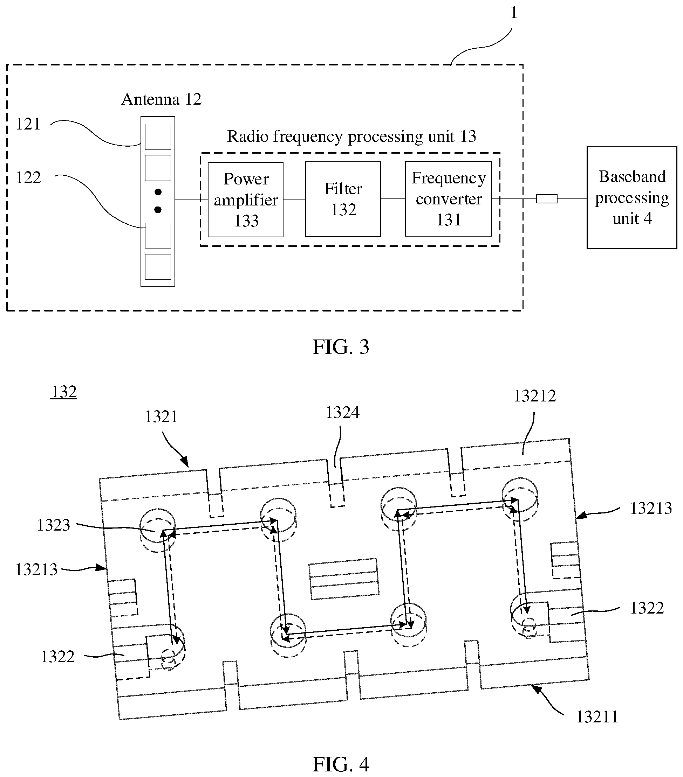

More specifically, refer to both FIG. 2 and FIG. 3. FIG. 3 is a diagram of composition of an AAU according to a possible embodiment of this application. The AAU 1 may further include an antenna 12 and a radio frequency processing unit 13. The radio frequency processing unit 13 is connected to a feed structure of the antenna 12. The radio frequency processing unit 13 may be configured to: perform frequency selection, amplification, and frequency conversion processing on a signal received by the antenna 12, convert the processed signal into an intermediate frequency signal or a baseband signal, and send the intermediate frequency signal or the baseband signal to the baseband unit 4. Alternatively, the radio frequency processing unit 13 is configured to: perform up-conversion and amplification processing on an intermediate frequency signal of the baseband unit 4, convert the processed signal into an electromagnetic wave, and send the electromagnetic wave through the antenna 12. The baseband unit 4 is connected to the radio frequency processing unit 13, and is configured to process the intermediate frequency signal or the baseband signal sent by the radio frequency processing unit 13.

In a specific embodiment, the antenna 12 may include a reflecting plate 121 and a plurality of antenna elements 122, and the reflecting plate 121 and the antenna elements 122 may be disposed in the radome 11. The antenna element 122 may also be referred to as an antenna element, an element, or the like, and can effectively send or receive an antenna signal. The reflecting plate 121 may also be referred to as a base plate, an antenna panel, a reflecting surface, or the like, and may be made of a metal material. During signal receiving of the antenna 12, the reflecting plate 121 may reflect antenna signals to focus the antenna signals on a receiving point. During signal transmitting of the antenna 12, the reflecting plate 121 reflects a signal transmitted to the reflecting plate 121. The antenna element 122 is usually placed on a surface of one side of the reflecting plate 121. This can not only greatly enhance a capability of receiving or transmitting an antenna signal, but also block and shield interference of another electromagnetic wave from a back surface of the reflecting plate 121 on receiving of an antenna signal (in this application, the back surface of the reflecting plate 121 refers to a side opposite to the side that is of the reflecting plate 121 and on which the antenna element 122 is disposed).

In a specific embodiment, the radio frequency processing unit 13 may include a frequency converter 131, a filter 132, a power amplifier 133, and the like. In a signal transmitting direction, the frequency converter 131 may be configured to: up-convert a signal of the baseband unit 4 and transmit the signal to the filter 132 after the frequency conversion, the filter 132 filters the signal, then the filtered signal enters the power amplifier 133 for amplification, and finally the antenna 12 converts the amplified signal into an electromagnetic wave and sends the electromagnetic wave. In a signal receiving direction, the power amplifier 133 may be configured to: perform low-noise amplification on a signal received by the antenna 12 and transmit the amplified signal to the filter 132 for filtering, then the filtered signal is transmitted by the filter 132 to the frequency converter 131 for down-conversion, and the down-converted signal is transmitted to the baseband unit 4.

Performance of a filter, as a key component of a radio frequency front-end circuit, directly affects an overall communication capability of a base station. Currently, common filters include metal-cavity filters, dielectric filters, and the like. The dielectric filters are increasingly widely used in radio frequency processing units of base stations due to features of small size, low insertion loss, and good stability. With the continuous evolution of the base station, the base station has an increasingly high requirement for the performance of the filter. For example, the filter needs to have features such as high suppression and wideband filtering. However, the current dielectric filters commonly have a problem of weak strength of coupling between a connection port and a resonant cavity, resulting in a specific transmission delay and affecting further improvement of bandwidths of the filters.

In view of the foregoing problem, an embodiment of this application provides a dielectric filter. A port coupling coefficient of the dielectric filter can be adjusted through a corresponding structure design, to adjust a bandwidth of the dielectric filter. This provides feasibility for the dielectric filter to achieve a feature of wideband filtering. The following further describes this application in detail with reference to the accompanying drawings and specific embodiments.

FIG. 4 is a diagram of a structure of a dielectric filter according to an embodiment of this application. In the following embodiments, the dielectric filter and the filter are described using a same reference numeral. The dielectric filter 132 includes a dielectric body 1321. A shape of the dielectric body 1321 includes but is not limited to a cuboid, a cylinder, or some other block-like shapes. In FIG. 4, an example in which the dielectric body 1321 is a cuboid is used for description. A material of the dielectric body 1321 may be a ceramic. For example, a main component of the dielectric body 1321 includes but is not limited to a high-dielectric-constant ceramic such as barium titanate (BaTiO₃), barium carbonate (BaCO₃), a BaO-Ln₂O₃-TiO₃-2 system microwave dielectric ceramic, or a composite perovskite microwave dielectric ceramic. The dielectric body 1321 with a high dielectric constant can shorten a wavelength of an electromagnetic wave propagating inside the dielectric body 1321, thereby helping reduce a structural size of the dielectric body 1321. It should be noted that, in this embodiment of this application, the high dielectric constant may be understood as a relatively high dielectric constant that may be applied to the dielectric filter 132. For example, the dielectric constant may be greater than 6. However, this application does not exclude a case in which the dielectric constant is less than or equal to 6, provided that a filtering requirement is met.

In this embodiment, the dielectric body 1321 may include a first surface 13211 and a second surface 13212, and the first surface 13211 and the second surface 13212 may be opposite to each other in a first direction. In addition, the dielectric body 1321 may further include a side surface 13213. For example, when the dielectric body 1321 is a cuboid, the dielectric body 1321 may further include four side surfaces 13213 in addition to the first surface 13211 and the second surface 13212, and every two side surfaces 13213 are opposite to each other; or when the dielectric body 1321 is a cylinder, the side surface 13213 of the dielectric body 1321 is a circumferential surface of the cylinder.

The dielectric body 1321 may be provided with a coupling port 1322 and a resonant cavity 1323. The coupling port 1322 may extend from the side surface 13213 of the dielectric body 1321 to an interior of the dielectric body 1321, and may be configured to electrically connect to an external device. For example, the external device may be a frequency converter or a power amplifier. For example, there may be two coupling ports 1322. The two coupling ports may be close to two opposite side surfaces of the dielectric body 1321 respectively. The coupling port 1322 on the left side may be configured to electrically connect to a frequency converter, and the coupling port 1322 on the right side may be configured to electrically connect to a power amplifier. There may be one or more resonant cavities 1323. The one or more resonant cavities 1323 may be staggered between the two coupling ports 1322. Adjacent resonant cavities 1323 are coupled to each other, and a resonant cavity 1323 close to the coupling port 1322 and the coupling port 1322 may also be coupled to each other. In this way, signal energy can be transferred between the two coupling ports 1322, and a signal can be filtered. For example, in a signal transmitting direction, a signal may be coupled from the coupling port 1322 on the left side to the coupling port 1322 on the right side through each resonant cavity 1323 along a path indicated by solid lines in FIG. 4; and in a signal receiving direction, a signal may be coupled from the coupling port 1322 on the right side to the coupling port 1322 on the left side through each resonant cavity 1323 along a path indicated by dashed lines in FIG. 4. Herein, coupling may be understood as a connection manner in which there is no direct electrical contact between the coupling port 1322 and the resonant cavity 1323 or between different resonant cavities 1323, and signal energy transmission can be performed between the coupling port 1322 and the resonant cavity 1323 or between the resonant cavities 1323 through interaction, to implement signal transfer.

Certainly, in some other implementations, alternatively, the coupling port 1322 on the left side may be connected to a power amplifier, and the coupling port 1322 on the right side may be connected to a frequency converter. In this case, in a signal transmitting direction, a signal may be coupled from the coupling port 1322 on the right side to the coupling port 1322 on the left side through each resonant cavity 1323 along a path indicated by dashed lines in FIG. 4; and in a signal receiving direction, a signal may be coupled from the coupling port 1322 on the left side to the coupling port 1322 on the right side through each resonant cavity 1323 along a path indicated by solid lines in FIG. 4.

In addition, the dielectric body 1321 may be further provided with one or more coupling windows 1324, and these coupling windows 1324 may be used to adjust a coupling coefficient between the resonant cavities 1323, to adjust a resonance frequency or a bandwidth of the dielectric filter 132 and thus improve filtering performance of the dielectric filter 132.

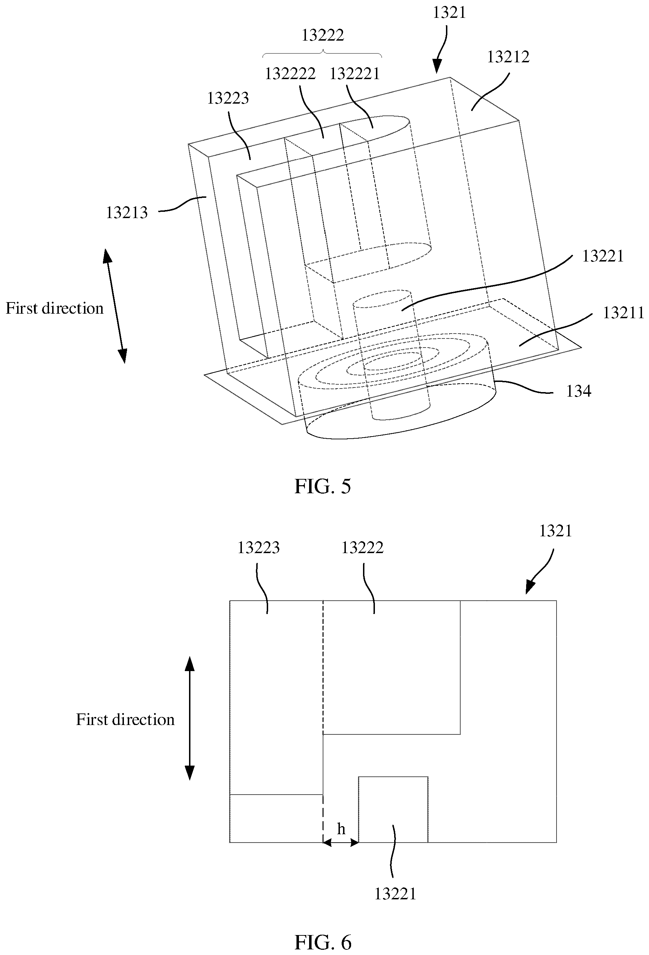

FIG. 5 is a diagram of a partial structure of the dielectric filter 132 shown in FIG. 4, and specifically relates to a part including the coupling port. In this embodiment, the coupling port 1322 may include a blind hole 13221 provided on the first surface 13211, and the blind hole 13221 may have a metalized inner wall, which facilitates electrical connection to the external device. For example, the blind hole 13221 of the coupling port 1322 may be electrically connected to the external device through a coaxial cable 134. During specific implementation, an inner conductor at one end that is of the coaxial cable 134 and that is connected to the dielectric filter 132 may be soldered to the metalized inner wall of the blind hole 13221. This can not only electrically connect the coaxial cable 134 to the blind hole 13221, but also relatively fasten the coaxial cable 134 to the dielectric filter 132 in terms of structure, thereby improving reliability of connection between the coaxial cable 134 and the dielectric filter 132. A process such as electroplating may be performed on the blind hole 13221 to form a metal plating layer on an inner wall of the blind hole 13221, thereby implementing the metalized inner wall. A material of the metalized inner wall of the blind hole 13221 includes but is not limited to silver, gold, tin, or the like.

Still refer to FIG. 5. The coupling port 1322 may further include a first slot 13222 and a second slot 13223. The first slot 13222 is provided on the second surface 13212 of the dielectric body 1321. The second slot 13223 is provided on the side surface 13213 of the dielectric body 1321. The first slot 13222 may extend in a direction of the side surface 13213 of the dielectric body 1321 and communicate with the second slot 13223. A projection of an outer contour of the first slot 13222 on the first surface 13211 of the dielectric body 1321 may partially cover the blind hole 13221 provided on the first surface 13211, or may completely cover the blind hole 13221. The electroplating process may also be performed on an inner wall of the first slot 13222 and an inner wall of the second slot 13223 to form metalized inner walls. Similarly, materials of the metalized inner walls of the first slot 13222 and the second slot 13223 include but are not limited to silver, gold, tin, or the like. In this case, an entire slot structure formed by the first slot 13222 and the second slot 13223 can be used as a resonant cavity of the dielectric filter 132. The resonant cavity may be coupled to the blind hole 13221, and may also be coupled to another resonant cavity that is close to the coupling port and at the dielectric body 1321, to transfer signal energy received by the blind hole 13221 to the another resonant cavity.

Still refer to FIG. 5. During specific implementation, the first slot 13222 may include a semicircular slot 132221 and a rectangular slot 132222 communicating with the semicircular slot 132221, the semicircular slot 132221 may be located on a side that is of the rectangular slot 132222 and that is away from the side surface 13213, and an opening of the semicircular slot 132221 faces the rectangular slot 132222, so that the semicircular slot 132221 communicates with the rectangular slot 132222 at the opening. This structure can improve a quality factor (q value) of the dielectric filter 132, thereby helping improve the filtering performance of the dielectric filter 132. For example, a width of the rectangular slot 132222 may be equal to a diameter of the semicircular slot 132221. In this case, a shape of a cross section that is of the first slot 13222 and that is perpendicular to the first direction approximates half a racetrack. For example, when the dielectric body 1321 is the cuboid, a shape of a cross section of the second slot 13223 may be a rectangle, and a width of the second slot 13223 is equal to the width of the rectangular slot 132222.

In this embodiment of this application, depths of the second slot 13223 and the first slot 13222 in the first direction may be the same, or may be different. In other words, a bottom wall of the first slot 13222 and a bottom wall of the second slot 13223 may be on a same plane, or there may be a height difference between a bottom wall of the first slot 13222 and a bottom wall of the second slot 13223. In this case, a step may be formed between the bottom wall of the first slot 13222 and the bottom wall of the second slot 13223. The depth of the first slot 13222 and the depth of the second slot 13223 both affect a resonance frequency of the resonant cavity. Specifically, a greater depth of the first slot 13222 indicates a lower resonance frequency of the resonant cavity, and conversely, a smaller depth of the first slot 13222 indicates a higher resonance frequency of the resonant cavity; and a greater depth of the second slot 13223 indicates a higher resonance frequency of the resonant cavity, and conversely, a smaller depth of the second slot 13223 indicates a lower resonance frequency of the resonant cavity. It can be learned that the depths of the two slots have opposite impact on the resonance frequency of the resonant cavity. Based on this principle, the depth of the first slot 13222 and the depth of the second slot 13223 may be adjusted based on a design parameter of the dielectric filter 132, so that the resonance frequency of the resonant cavity meets a requirement for specific performance of the dielectric filter 132.

In addition, the depth of the first slot 13222 not only affects the resonance frequency of the resonant cavity, but also affects strength of coupling between the first slot 13222 and the blind hole 13221. A deeper depth of the first slot 13222 indicates a shorter distance between the bottom wall of the first slot 13222 and a bottom wall of the blind hole 13221. As a result, the strength of coupling between the first slot 13222 and the blind hole 13221 is improved, thereby reducing a port delay and further improving the bandwidth of the dielectric filter 132.

It can be learned from the foregoing analysis that, when the depth of the first slot 13222 is increased, port coupling strength of the dielectric filter 132 can be improved, and the resonance frequency of the resonant cavity can be reduced. However, in some cases, if the dielectric filter 132 needs to remain at an original resonance frequency while expecting to increase the bandwidth, the depth of the second slot 13223 may be increased, for example, the depth of the second slot 13223 may be caused to be greater than the depth of the first slot 13222, to increase the resonance frequency. In this way, a frequency reduction caused by the first slot 13222 can be offset by a frequency increase caused by the second slot 13223. As a result, the port coupling strength is improved, the delay is reduced, and the dielectric filter can remain at the original resonance frequency.

Refer to both FIG. 5 and FIG. 6. FIG. 6 is a diagram of a cross-sectional structure of the dielectric filter, shown in FIG. 5, from a side perspective. In some embodiments, a projection of an outer contour of the second slot 13223 on the first surface 13211 may be spaced from the blind hole 13221 provided on the first surface 13211. As shown in FIG. 6, a spacing between the projection of the outer contour of the second slot and the blind hole is h. As a result, a risk that the second slot 13223 interferes with the blind hole when the depth of the second slot 13223 is relatively large can be reduced, and therefore structural reliability of the dielectric filter 132 can be improved.

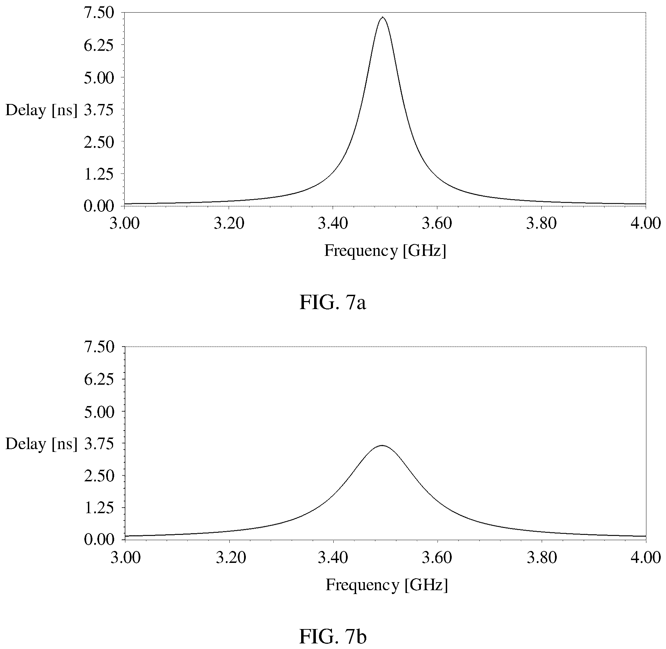

Refer to both Fig.7a and Fig.7b. A coupling solution in which a resonance frequency of a resonant cavity is 3.5 GHz is used as an example. When hole depths of blind holes 13221 are the same, port delays of a conventional dielectric filter and the dielectric filter provided in embodiments of this application are separately simulated. FIG. 7a shows a simulation result of the conventional dielectric filter. FIG. 7b shows a simulation result of the dielectric filter provided in embodiments of this application. It can be learned that the delay of the conventional coupling solution is approximately 7.3 ns, but the delay of the dielectric filter provided in embodiments of this application is only approximately 3.65 ns. Compared with the port delay of the conventional solution, the port delay of the dielectric filter in embodiments of this application can be reduced by half, that is, a relative bandwidth of the dielectric filter is doubled.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A dielectric filter, comprising a dielectric body, and a coupling port and a resonant cavity that are provided at the dielectric body, wherein the dielectric body has a first surface, a second surface, and a side surface; the first surface and the second surface are opposite to each other; and the coupling port extends from the side surface to an interior of the dielectric body; and
the coupling port comprises a blind hole provided on the first surface, a first slot provided on the second surface, and a second slot provided on the side surface; the first slot extends in a direction of the side surface and communicates with the second slot; a projection of an outer contour of the first slot on the first surface covers at least a part of the blind hole; the blind hole, the first slot, and the second slot each have a metalized inner wall; and the blind hole is coupled to the first slot.

2. The dielectric filter according to claim 1, wherein a depth of the first slot is different from a depth of the second slot in a first direction; and
the first direction is an arrangement direction of the first surface and the second surface.

3. The dielectric filter according to claim 2, wherein the depth of the second slot is greater than the depth of the first slot in the first direction.

4. The dielectric filter according to claim 2 or 3, wherein a projection of an outer contour of the second slot on the first surface is spaced from the blind hole.

5. The dielectric filter according to any one of claims 2 to 4, wherein the first slot comprises a semicircular slot and a rectangular slot communicating with the semicircular slot, an opening of the semicircular slot faces the rectangular slot, and the semicircular slot is located on a side that is of the rectangular slot and that is away from the side surface.

6. The dielectric filter according to any one of claims 1 to 5, wherein the dielectric body is a cuboid, and the second slot is provided on one of side surfaces of the dielectric body.

7. The dielectric filter according to any one of claims 1 to 5, wherein the dielectric body is a cylinder.

8. The dielectric filter according to any one of claims 1 to 7, wherein a material of the dielectric body is ceramic.

9. A radio frequency processing unit, comprising a power amplifier and the dielectric filter according to any one of claims 1 to 8, wherein the coupling port of the dielectric filter is connected to the power amplifier.

10. A base station, comprising an antenna, a baseband unit, and the radio frequency processing unit according to claim 9, wherein the radio frequency processing unit is connected between the baseband unit and the antenna.
